# EUROPEAN PATENT SPECIFICATION

(11) **EP 2 421 039 B1**
(45) Date of publication and mention of the grant of the patent: **22.10.2014**
(21) Application number: 10173353.3
(22) Date of filing: 19.08.2010
(51) Int. Cl.: H01L 25/075, F21K 99/00, G02B 17/08, H01L 33/48

(54) **Light emitting apparatus**
Lichtemittierende Vorrichtung
Appareil électroluminescent

(43) Date of publication of application: 22.02.2012
(73) Proprietor: Liang Meng Plastic Share Co. Ltd., Shulin City, Taipei 238 (TW)
(72) Inventor: Lai, Guang-Juh, 238, Shulin City, Taipei County (TW)
(74) Representative: 2K Patentanwälte Blasberg Kewitz & Reichel

(56) References cited:
- DE-A1-102004 004 778
- JP-A- 2003 110 146
- JP-A- 2005 223 216
- US-A1- 2004 183 081
- US-A1- 2007 279 904

## Description

### BACKGROUND OF THE INVENTION

### FIELD OF THE INVENTION

The present invention relates to an illumination apparatus, particularly relates to an illumination apparatus adopted light emitting diodes as light sources.

### DESCRIPTION OF RELATED ART

Light emitting diodes have advantages of saving electrical power, which makes them possible to replace traditional light bulb and to be used as next generation light sources.

White light emitting devices, which are most popularly used in the field of general lighting, need to be packaged before they are applied into practical use. They usually have some packaging processes described hereinafter. At first, a light emitting chip is disposed on a substrate, and a florescent layer for converting light wavelength is formed on the light emitting chip. Then, liquid encapsulating material is further formed on the florescent layer and the light emitting chip. Then, a curing treatment is performed to cure the liquid encapsulating material so as to seal the fluorescent layer and the light emitting chip. Besides, a lens with specific curvature can be formed on the encapsulating material to control the divergent angle of the light emitted from the light emitting chip.

Conventional fluorescent layer is made by dispensing or coating a liquid layer on the top face and peripheral face of the light emitting chip and then curing the liquid layer. However, the surface of the liquid fluorescent layer is affected by the surface tension and is usually of spherical shaped. Therefore, consistent thickness is hard to obtain on both the top face and peripheral face of the light emitting chip. Consequently, white light emitted from the light emitting diodes cannot be uniform in all directions.

In another aspect, since each individual packaged light emitting device can only provide a small amount of light intensity, a plurality of packaged light emitting devices have to be arranged together on a circuit board to get enough light intensity for practical use. For aesthetic purpose, an additional transparent cover is provided on the circuit board to cover the circuit traces and the electronic elements on the circuit board. However, transparent cover will partially absorb or reflect the light emitted from the packaged light emitting devices. That leads to decreasing the amount of light available for use. Besides, the transparent cover also increases the manufacturing cost.

### SUMMARY OF THE INVENTION

The objective of the present invention is to provide a LED street lamp having corresponding heat dissipating holes on both the top and bottom shell so as to allow heated air in the lamp housing to naturally flow upwardly and effectively increase the speed of airflow to dissipate operating heat generated from the LEDs.

Accordingly, the present invention provides a light emitting apparatus including a circuit board, at least one light emitting chip, an integrated optical cover and a fluorescent layer. The light emitting chip is arranged on the circuit board. The integrated optical cover has a peripheral wall, a top wall and a light guiding post. The peripheral wall is arranged around the outer edge of the circuit board. The top wall is arranged on the upper edge of the peripheral wall. The light guiding post extends from the top wall toward the light emitting chip. The light guiding post includes an end face having a recess portion. The outer edge of the end face is against the circuit board. The light emitting chip is accommodated in the recess portion. The fluorescent layer is arranged between the recess portion and light emitting chip.

This invention uses the recess portion of the light guiding posts and the light emitting chip cooperatively to confine the shape of the fluorescent layer, so the thickness of the fluorescent layer can be controlled to be consistent on both the top face and the peripheral face of the light emitting chip and the white light distribution can be uniform. Also, the one-piece formed integrated optical cover is able not only to package the circuit board by the peripheral wall and the top wall, but also to package the light emitting chip by corresponding light guiding post. No additional transparent cover as conventional is needed, and the structure of the light emitting apparatus can be simplified.

### BRIEF DESCRIPTION OF THE DRAWINGS

FIG. 1 is a perspective view of the light emitting apparatus of the present invention;
FIG. 2 is a partial exploded view of the light emitting apparatus of the present invention; and
FIG. 3 is cross-sectional view of the light emitting apparatus of the present invention.

### DETAILED DESCRIPTION OF THE INVENTION

The technical characteristics and contents of the present invention will become apparent with the following detailed description accompanied with related drawings.

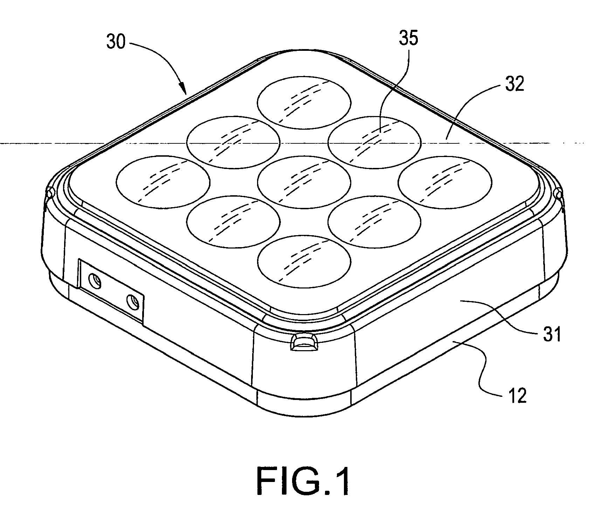

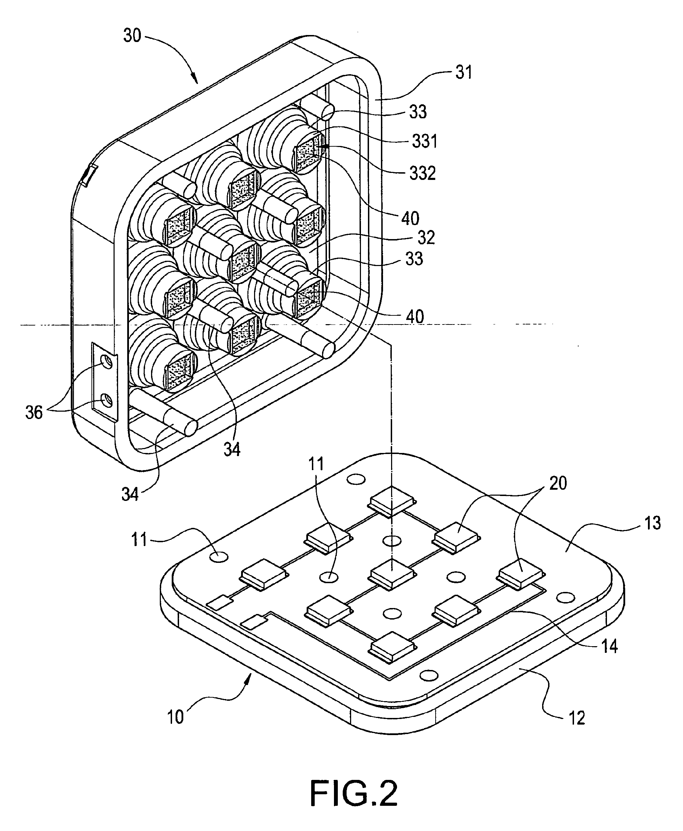

FIG. 1 and FIG. 2 show a light emitting apparatus according to an embodiment of the present invention. The light emitting apparatus mainly includes a circuit board 10, a plurality of the light emitting chips 20, an integrated optical cover 30, and a plurality of fluorescent layer 40.

The circuit board 10 is substantially of rectangular-shape and has a plurality of positioning holes 11 thereon. The circuit board 10 has a metal base plate 12 for dissipating heat generated from the light emitting chip 20, an insulating layer 13 disposed on the metal base plate 12, and a circuit pattern 14 on the insulating layer 13. The number of the positioning holes 11 is not limited to the number shown in the figure and can be at least one in practical use.

The light emitting chips 20 are arranged on the circuit board 10 in intervals and electrically connected to the circuit pattern 14. In this embodiment, the manner that the circuit pattern 14 electrically connects the light emitting chips 20 is, but not limited thereto, in serial relation. Besides, the number of the light emitting chips is not limited to the number shown in the figure, and can be at least one.

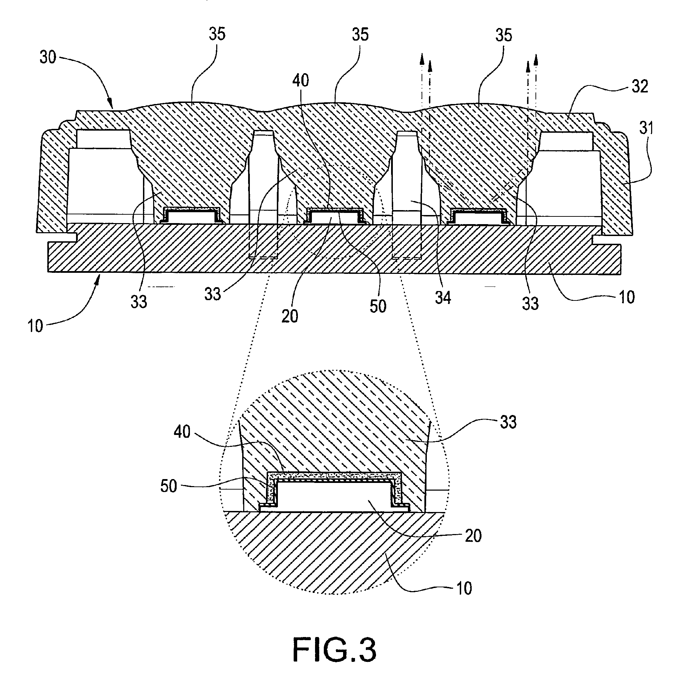

As FIG. 2 and FIG. 3 show, the integrated optical cover 30 has a peripheral wall 31 arranged around the outer edge of the circuit board 10, a top wall 32 arranged on the upper edge of the peripheral wall 31, a light guiding post 33 downwardly extending from the top wall 32 and toward the light emitting chips 20, and a positioning post 34 extending from the top wall 32 and tightly inserted into the positioning hole 11.

Each of the light guiding posts 33 has an end face 331 having a recess portion 332. The outer edge of the end face 331 is against the circuit board 10. The light emitting chip 20 are accommodated in the recess portions 332. It should be noted that, the diameter of each of the light guiding posts 33 decreases from the top wall 32 to the end face 331, so as to converge light beams emitted from the light emitting chips 20 toward the optical axis of the light guiding posts 33 and to increase the light output efficiency. The number of the light guiding posts 33 should be consistent with the number of the light emitting chips 20.

Besides, a convex portion 35 for converging light is formed on the top wall 32 and located at the opposite side of the light guiding post 32. Also, at least one plug hole 36 can be formed on the integrated optical cover 30 for electrically connecting the circuit board 10 with external electrical power (not shown).

In addition, the peripheral wall 31, the top wall 32, the light guiding posts 33, the convex portion 35 and the positioning post 34 of the integrated optical cover 30 are one-piece formed by plastic molding. Thus, the number of the components of the light apparatus of the present invention can be decreased, and the manufacturing cost and assembling time can also be reduced.

The fluorescent layers 40 can be used to convert the wavelength of a part of light emitted from the light emitting chips 20 and to form white light. Each of the fluorescent layers 40 is arranged between the recess portion 332 and light emitting chip 20. Besides, an adhesive silicone layer 50 is arranged between each of the fluorescent layers 40 and each of the light emitting chips 20.

Accordingly, since the shape of the fluorescent layer 40 is confined by the recess portion 332 and the light emitting chips 20, the thickness of the fluorescent layer 40 can be consistent on both the top face and the peripheral face of the light emitting chip 20, and the fluorescent layer 40 can be avoided from forming conventional spherical shaped due to surface tension and leading to non-uniform white light distribution in all directions.

By using the recess portion 332 of the light guiding posts 33 and the light emitting chips 20 cooperatively to confine the shape of the fluorescent layers 40, the thickness of the fluorescent layer 40 can be controlled to be consistent on both the top face and the peripheral face of the light emitting chips 20 and uniform white light distribution can be provided.

In another aspect, the one-piece formed integrated optical cover 30 is able not only to package the circuit board 10 by the peripheral wall 31 and the top wall 32 to avoid exposing the circuit and electrical components thereon, but also to package each of the light emitting chips 20 by corresponding light guiding post 33. Since there is no additional transparent cover as conventional, the structure of the light emitting apparatus can be simplified, the amount of light available for use can increase and the manufacturing cost can also be reduced.
In summary a light emitting apparatus is disclosed, the apparatus including a circuit board 10, at least one light emitting chip 20, an integrated optical cover 30 and a fluorescent layer 40. The light emitting chip 20 is arranged on the circuit board 10. The integrated optical cover 30 has a peripheral wall 31, a top wall 32 and a light guiding post 33. The peripheral wall 31 is arranged around the circuit board 10. The top wall 32 is arranged on the peripheral wall 31. The light guiding post 33 extends from the top wall 32 toward the light emitting chip 20. The light guiding post 33 includes a recess portion 332. The light emitting chip 20 is accommodated in the recess portion 332. The fluorescent layer 40 is arranged between the recess portion 332 and the light emitting chip 20. By using the recess portion 332 and the light emitting chip20 cooperatively to confine the fluorescent layer 40, the thickness thereof can be controlled to be consistent.

## Claims

1. A light emitting apparatus, comprising:
a circuit board (10);
at least one light emitting chip (20) arranged on the circuit board (10;
an integrated optical cover (30) having a peripheral wall (31) arranged around the outer edge of the circuit board (10), a top wall (32) arranged on the upper edge of the peripheral wall (31), and a light guiding post (33) extending from the top wall (32) and toward the light emitting chip (20), wherein the light guiding post (33) comprises an end face (331) having a recess portion (332) and the outer edge of the end face (331) is against the circuit board (10) and the light emitting chip (20) is accommodated in the recess portion (332); and
wherein a fluorescent layer (40) is arranged between the recess portion (332) and the light emitting chip (20), wherein an adhesive layer (50) is arranged between the fluorescent layer (40) and the light emitting chip (20) and wherein the shape of each of the fluorescent layer (40) is confined by the recess portion (332) and the light emitting chip (20).

2. The light emitting apparatus of claim 1, wherein the diameter of the light guiding post (33) decreases from the top wall (32) to the end face (331).

3. The light emitting apparatus of claim 1, wherein at least one plug hole (36) is formed on the integrated optical cover (30) for electrically connecting the circuit board (10) with external electrical power.

4. The light emitting apparatus of claim 1, wherein the circuit board (10 has a metal base plate (12), an insulating layer (13) disposed on the metal base plate (12), and a circuit pattern (14) on the insulating layer (13).

5. The light emitting apparatus of claim 1, wherein a convex portion for converging light is formed on the top wall and located at the opposite side of the light guiding post.

6. The light emitting apparatus of claim 5, wherein the circuit board (10) has at least one positioning hole (11) and the integrated optical cover (30) has a positioning post (34) extending from the top wall (32) and tightly inserted into the positioning hole (11).

7. The light emitting apparatus of claim 6, wherein the peripheral wall (31), the top wall (32), the light guiding post (33), the convex portion (35) and the positioning post (34) of the integrated optical cover (30) are one-piece formed.

## Patentansprüche

1. Lichtemittierende Vorrichtung, umfassend:
eine Leiterplatte (10);
mindestens einen lichtemittierenden Chip (20), der auf der Leiterplatte (10) angeordnet ist;
eine integrierte optische Abdeckung (30) mit einer Umfangswand (31), die um den Außenrand der Leiterplatte (10) angeordnet ist, eine obere Wand (32), die an dem oberen Rand der Umfangswand (31) angeordnet ist, und einen Lichtführungsstab (33), der sich von der oberen Wand (32) und in Richtung des lichtemittierenden Chips (20) erstreckt, wobei der Lichtführungsstab (33) eine Endfläche (331) mit einem Aussparungsabschnitt (332) aufweist, und wobei der Außenrand der Endfläche (331) gegen die Leiterplatte (10) gerichtet ist, und wobei der lichtemittierende Chip (20) in dem Aussparungsabschnitt (332) untergebracht ist; und
wobei eine fluoreszierende Schicht (40) zwischen dem Aussparungsabschnitt (332) und dem lichtemittierenden Chip (20) angeordnet ist, wobei eine Klebeschicht (50) zwischen der fluoreszierenden Schicht (40) und dem lichtemittierenden Chip (20) angeordnet ist, und wobei die Form jeder fluoreszierenden Schicht (40) durch den Aussparungsabschnitt (332) und dem lichtemittierenden Chip (20) begrenzt ist.

2. Lichtemittierende Vorrichtung nach Anspruch 1, wobei der Durchmesser des Lichtführungsstabes (33) von der oberen Wand (32) zu der Endfläche (331) hin abnimmt.

3. Lichtemittierende Vorrichtung nach Anspruch 1, wobei mindestens eine Steckeröffnung (36) auf der integrierten optischen Abdeckung (30) ausgebildet ist zum elektrischen Verbinden der Leiterplatte (10) mit externem elektrischem Strom.

4. Lichtemittierende Vorrichtung nach Anspruch 1, wobei die Leiterplatte (10) eine Metellbesisplatte (12), eine Isolierschicht (13), die auf der Metallbasisplatte (12) angeordnet ist, und ein Schaltungsmuster (14) auf der Isolierschicht (13) aufweist.

5. Lichtemittierende Vorrichtung nach Anspruch 1, wobei ein konvexer Abschnitt zum Konvertieren von Licht an der oberen Wand ausgebildet ist und an der gegenüberliegenden Seite des Lichtführungsstabes angeordnet ist.

6. Lichtemittierende Vorrichtung nach Anspruch 5, wobei die Leiterplatte (10) zumindest ein Positionierungsloch (11) aufweist, und die integrierte optische Abdeckung (30) einen Positionierungsstab (34) aufweist, der sich von der oberen Wand (32) erstreckt und fest in das Positionierungsloch (11) eingesetzt ist.

7. Lichtemittierende Vorrichtung nach Anspruch 6, wobei die Umfangswand (31), die obere Wand (32), der Lichtführungsstab (33), der konvexe Abschnitt (35) und der Positionierungsstab (34) der integrierten optischen Abdeckung (30) aus einem Stück gebildet sind.

## Revendications

1. Un appareil électroluminescent, comprenant :
un circuit imprimé (10) ;
au moins une puce électroluminescente (20) disposée sur le circuit imprimé (10) ;
un couvercle optique intégré (30) ayant une paroi périphérique (31) disposée autour du bord extérieur du circuit imprimé (10), une paroi supérieure (32) disposée sur le bord supérieur de la paroi périphérique (31), et un guide de lumière (33) s'étendant depuis la paroi supérieure (32) jusque vers la puce électroluminescente (20), dans lequel le guide de lumière (33) comporte une face terminale (331) ayant une partie évidée (332) et le bord extérieur de la face terminale (331) étant disposé contre le circuit imprimé (10) et la puce électroluminescente (20) étant disposée à l'intérieure de la partie évidée (332) ; et
dans lequel une couche fluorescente (40) est disposée entre la partie évidée (332) et la puce électroluminescente (20), dans laquelle une couche adhésive (50) est disposée entre la couche fluorescente (40) et la puce électroluminescente (20) et dans laquelle la forme de chacune des couches fluorescentes (40) est confinée par la partie évidée (332) et la puce électroluminescente (20).

2. L'appareil électroluminescent de la revendication 1, dans lequel le diamètre du guide de lumière (33) décroît depuis la paroi supérieure (32) jusqu'à la face terminale (331).

3. L'appareil électroluminescent de la revendication 1, dans lequel au moins un orifice de branchement (36) est formé sur le couvercle optique intégré (30) pour la connexion électrique du circuit imprimé (10) avec une alimentation électrique externe.

4. L'appareil électroluminescent de la revendication 1, dans lequel le circuit imprimé (10) comporte une plaque de base métallique (12), une couche d'isolation (13) disposée sur la plaque de base métallique (12), et un motif de circuits (14) sur la couche d'isolation (13).

5. L'appareil électroluminescent de la revendication 1, dans lequel l'on forme une partie convexe convergente est formée sur la paroi supérieure et disposée sur le côté opposé du guide de lumière.

6. L'appareil électroluminescent de la revendication 5, dans lequel le circuit imprimé (10) dispose au moins un orifice de positionnement (11) et le couvercle optique intégré (30) dispose d'un mat de positionnement (34) s'étendant depuis la paroi supérieure (32) et fermement insérée à l'intérieur de l'orifice de positionnement (11).

7. L'appareil électroluminescent de la revendication 6, dans lequel la paroi périphérique (31), la paroi supérieure (32), le guide de lumière (33), la partie convexe (35) et le mat de positionnement (34) du couvercle optique intégré (30) sont de fabrication.
